(19) Europäisches Patentamt / European Patent Office / Office européen des brevets

(11) **EP 1 841 065 A1**

(12) **EUROPEAN PATENT APPLICATION**

(43) Date of publication:
**03.10.2007 Bulletin 2007/40**

(51) Int Cl.:
*H03H 21/00* $^{(2006.01)}$

(21) Application number: **06111900.4**

(22) Date of filing: **29.03.2006**

| | |
|---|---|
| (84) Designated Contracting States: **AT BE BG CH CY CZ DE DK EE ES FI FR GB GR HU IE IS IT LI LT LU LV MC NL PL PT RO SE SI SK TR** Designated Extension States: **AL BA HR MK YU** (71) Applicant: **Mitel Networks Corporation Ottawa, ON K2K 2W7 (CA)** (72) Inventor: **Beaucoup, Frank Ottawa, Ontario K2B 8E1 (CA)** | (74) Representative: **Read, Matthew Charles et al Venner Shipley LLP 20 Little Britain London EC1A 7DH (GB)** Remarks: A request for correction of the claims has been filed pursuant to Rule 88 EPC. A decision on the request will be taken during the proceedings before the Examining Division (Guidelines for Examination in the EPO, A-V, 3.). |

(54) **Modified least-mean-squares method with reduced computational complexity**

(57) A method for implementing a Least-Mean-Squares (LMS) adaptive digital filter for filtering a reference signal ($X_n$) using weighting coefficients ($H_n$) that are adapted by an error signal ($e_n$) equal to the difference between a desired signal ($d_n$) and the output $H_n^* X_n$ of the adaptive filter, wherein the method comprises updating the coefficient-vector ($H_n$) using a previous sample of the error signal ($e_{n-1}$), and updating the error signal ($e_n$) using the updated coefficient-vector ($H_n$).

Figure 2: modified LMS algorithm

EP 1 841 065 A1

**Description**

FIELD OF THE INVENTION

The present invention relates generally to digital filters, and more particularly, to a method of implementing Least-Mean-Squares (LMS) adaptive filtering with a general-purpose Digital Signal Processor (DSP) having a single-cycle multiply-and-accumulate function and dual-access memory.

BACKGROUND OF THE INVENTION

The Least-Mean-Square (LMS) algorithm was introduced in 1960 by Bernard Widrow [B. Widrow and M.E. Hoff, "Adaptive switch circuits," IRE WESCON Convention Record, Part 4, pp. 96-104, 1960], and has since become an essential tool for use in adaptive -signal processing. Presently, it is the most widely used adaptive filtering algorithm in such fields as control systems, adaptive channel equalisation, adaptive beamforming, and echo cancellation, among others [S. Haykin and B. Widrow, Editors, "Least-Mean-Square adaptive filters," Wiley, 2003].

In order to reduce the computational complexity of the LMS algorithm, numerous algorithmic variants have been developed; some of them being general in scope and others being application-specific. Without exception, the reduction in computational complexity provided by these variants is achieved at the expense of performance (in terms of speed, depth of convergence, or delay) or memory footprint, or both.

The computational complexity of the LMS algorithm grows linearly with the length of the adaptive filter. In some applications such as Acoustic Echo Cancellation (AEC), very large adaptive filters (e.g., with thousands of taps) are needed and the resulting complexity can become considerable. Over the years, significant research efforts have been expended to reduce the complexity of LMS, both at the hardware level (processor architectures) and at the software level (algorithms).

In terms of hardware, new processor architectures have been targeted to the LMS algorithm, [see T.A. Williams, *"Pipelined processor for implementing the least-mean-squares algorithm,"* US Patent 4947363, 1990].

In software, numerous variants of the LMS algorithm have been developed, such as block-processing algorithms in the time domain, to take advantage of fast convolution techniques, as well as tap-selective algorithms where only a subset of the filter taps are updated at each iteration [see O. Tanrikulu and K. Dogancay, *"Selective-partial-update proportionate normalized least-mean-square adaptive filtering for network echo cancellation,"* US Patent Application 10/374,738 (Pub. # US 2004/0015529), and J. Benesty, T.F. Gaensler, S.L. Gay, and M.M. Sondhi, *"Dynamic allocation of resources for echo cancellation,"* US Patent Application US1999/0431847, 1999]. Also, sub-band algorithms have been developed to take advantage of the reduction in complexity resulting from the down-sampling process. Frequency-domain algorithms have also been introduced to benefit from fast convolution based on DFT transform techniques such as the Fast Fourier Transform (FFT), as well as bin-per-bin power normalisation resulting in faster convergence. Detailed presentations of both sub-band and frequency-domain algorithms in the specific context of echo cancellation, are set forth in J. Benesty, T.F. Gaensler, D.R. Morgan, M.M. Sondhi and S.L. Gay, "Advances in network and acoustic echo cancellation", Springer, 2001 and E. Hansler and G. Schmidt, "Acoustic echo and noise control, a practical approach," Wiley, 2004.

Application-specific algorithms have also been designed to reduce the computational complexity of the LMS algorithm. For example, in Line Echo Cancellation (LEC) the reflection causing the echo can be located anywhere in a time interval of 64ms or even 128ms (512 taps and 1024 taps, respectively, with 8KHz sampling rate), but typically occupies only a very short portion of this time interval (5 to 10ms). To deal with this phenomenon in an efficient manner in terms of computational complexity, sparse algorithms have been designed, as set forth for example in M. Popovic, D. Schulz and J. Radecki, *"Line echo cancellation system,"* US Patent Application 2003/0223575. These algorithms essentially try to locate the reflection in the entire time interval and then use a short adaptive filter to cancel the echo in that region, most often with the LMS algorithm for adaptation. Although these algorithms provide efficient echo cancellation, they have to accommodate sudden changes in the position of the reflection during a call, for example as a result of call-forwarding. The boundaries of the active region are therefore usually required to be updated in real time using a control mechanism [see L. Demirekler and A. Purkovic, *"Apparatus and method for echo cancellation,"* US Patent Application 11/027,515 (Pub. # US 2005/0117739 A1), 2004 and P.M. Yatrou and D.J. Millar, *"Adaptive sparse echo canceller using a sub-rate filter for active tap selection,"* US Patent US1992000894377, 1992].

For general-purpose, full-band, non-sparse algorithms, Texas Instruments recommends a variant of the LMS algorithm and provides a special lms instruction on some of their DSPs [see Texas Instruments, *"TMS320C55x DSP mnemonic instruction set reference guide,"* SPRU374G, Oct 02] to implement this algorithm efficiently. This algorithm, as set forth in S. De Gregorio, J. Chaoui, Y. Masse, "Tradeoffs in DSP implementations of NLMS-based echo cancellers," Proc. ICSPAT '98, vol. 1, pp. 72 - 76, Sep 98, is referred to as the Modified DSP Delayed LMS (M-DSP-DLMS). The M-DSP-DLMS can be implemented on most general-purpose DSPs (including the Texas Instruments DSP with the *lms*

instruction) in 2 cycles per adaptive-filter tap instead of 3 cycles per adaptive-filter tap for the traditional LMS algorithm. However, as discussed in greater detail below, it has been found that M-DSP-DLMS is characterized by slower convergence than LMS.

SUMMARY OF THE INVENTION

According to the present invention, a method is provided for implementing a full-band, non-sparse variant of the LMS algorithm in 2 cycles per adaptive-filter tap on most general-purpose DSPs, without significant loss in terms of performance or memory footprint, as compared with the traditional LMS algorithm.

The method of the present invention is based on the same principle as the Modified DSP Delayed LMS described in De Gregorio et al, in that both the error calculation and the adaptive filter (or coefficient-vector) update are performed in the same loop on the length of the coefficient vector. Also, as set forth in De Gregorio et al, the coefficient-vector update is performed using the previous sample of the error signal. However, according to the present invention the new sample of the error signal is calculated using the updated values of the adaptive coefficients as opposed to their values from the previous iteration. Consequently, each coefficient is updated and then used immediately for error calculation in the same loop.

The method of the present invention, referred to herein as the Modified LMS (M-LMS) algorithm, can be implemented in 2 cycles per adaptive-filter tap on most general-purpose DSPs and results in an error signal that is exactly identical to the LMS error signal. Only the knowledge of the coefficient vector is delayed by one sample compared to LMS. In terms of memory, as with DLMS one extra data word is needed in the reference history buffer as compared to LMS.

For further reduction in computational complexity, the method of the present invention can be combined with other resource allocation schemes such as those in Tanrikulu et al, Demirekler et al, Yatrou et al and the patent application of Benesty et al, as well as the sub-band structures set forth in the academic publications of Benesty et al and Hansler et al, referred to above.

BRIEF DESCRIPTION OF THE DRAWINGS

The invention will be better understood with reference to the following Figures in which:

Figure 1(a) is a realization diagram showing the conventional LMS algorithm, according to the prior art;

Figure 1(b) is a realization diagram showing the delayed LMS algorithm with one-sample delay, or M-DSP-DLMS algorithm, according to the prior art;

Figure 2 is a realization diagram showing the Modified Least-Mean-Squares algorithm according to the preferred embodiment, for implementation on a general-purpose Digital Signal Processor (DSP) having single-cycle multiply-and-accumulate and dual-access memory; and

Figure 3 is a diagram showing exemplary code for implementing the algorithm of Figure 2 in 2 cycles per adaptive-filter tap in assembler language for Analog Devices SHARC processors.

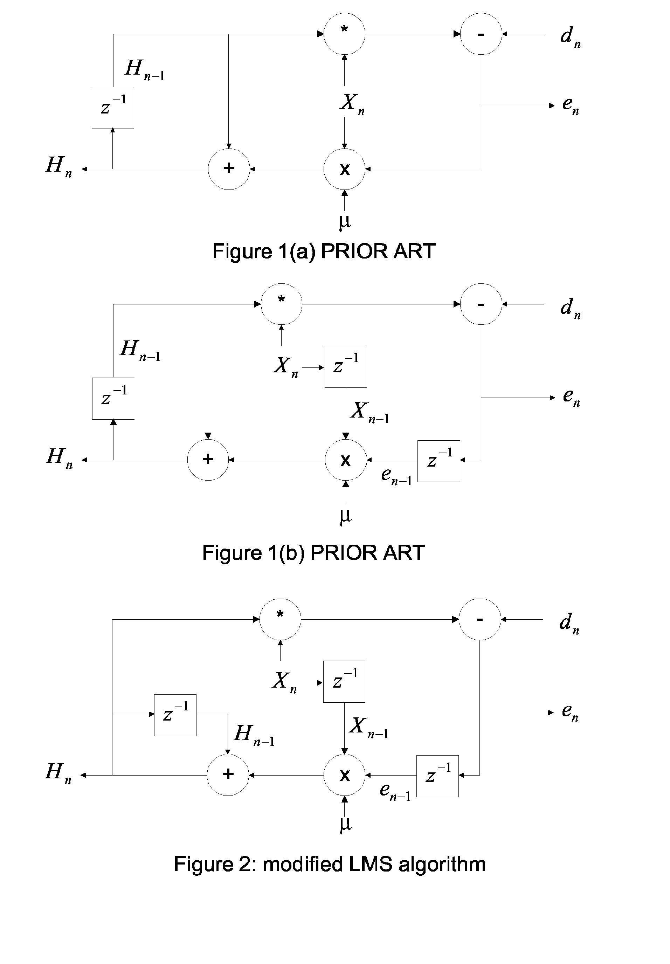

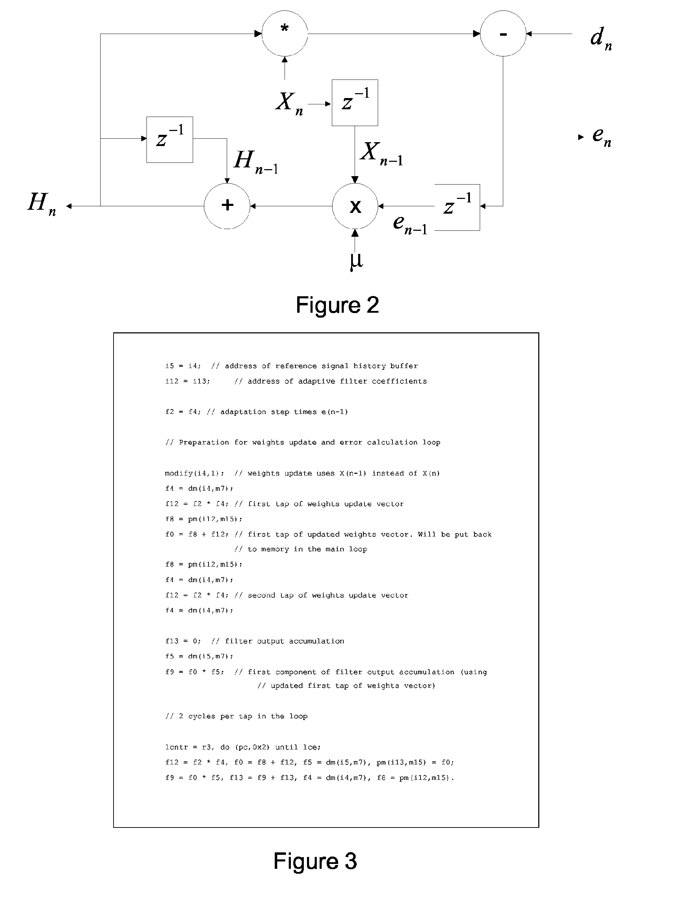

In the realization diagrams of Figures 1 (a), 1 (b) and 2, the * operator represents the following filtering operation: if $H$ and $X$ are two column vectors, then the * operator is defined as $H*X=H^{T}X=\Sigma H_{k}X_{k}$.

DETAILED DESCRIPTION OF THE PREFERRED EMBODIMENTS

The traditional LMS algorithm of Figure 1 (a) can be written as the following two steps:

$$\mathrm{LMS}/\mathrm{NLMS}:\begin{array}{l}(1)\ e_{n}=d_{n}-H_{n-1}*X_{n}\\(2)\ H_{n}=H_{n-1}+\mu e_{n}X_{n}\end{array}\ \text{(Equation 1),}$$

where at each step n of the iterative process, $H_{n}$ is the coefficient vector (that is, the adaptive filter) with $N$ taps, $X_{n}$ is the reference signal history buffer with the same length $N$, $d_{n}$ is the desired signal sample (the echo signal for echo cancellation applications), and $e_{n}$ is the error signal sample. The coefficient $\mu$ is the adaptation step size of the digital filter.

In the traditional LMS formulation of Equation 1, the error $e_{n}$ is first calculated, in one cycle per tap with dual memory access, and then used in the coefficient update. The coefficient update cannot take less than 2 cycles per tap since each tap coefficient has to be read from memory and written back into memory after its update. Because the result of the error calculation is needed for the whole update loop, the total computational complexity is 3 cycles per tap.

However, since the memory accesses are the same in both the error calculation loop and the update loop, the two loops can be combined provided the coefficient update is done with an error that is known a priori. As discussed in De Gregorio et al, the error $e_{n-1}$ from the previous sample may be used to compute the coefficient update.

The first implementation presented in De Gregorio et al simply consists of replacing $e_n$ by $e_{n-1}$ in the LMS equation 1, above, and is referred to as the "DSP-Delayed NLMS", where "delayed" stresses the fact that it is the delayed error that is used for the adaptation. The error calculation and coefficient update steps are reversed in "DSP-Delayed NLMS" to illustrate the fact that the adaptation is not based on the results of the current error calculation (although in practice both steps are executed in a single 2-cycles-per-tap loop), as follows:

$$\text{DSP - DNLMS}: \begin{array}{l} (1) \ H_n = H_{n-1} + \mu e_{n-1} X_n \\ (2) \ e_n = d_n - H_{n-1} * X_n \end{array} \quad \text{(Equation 2)}.$$

The "DSP-Delayed NLMS" algorithm, however, proves to be very unstable since the error $e_{n-1}$ that is multiplied with the reference buffer $X_n$ in the coefficient update is calculated based on $X_{n-1}$. To address this instability, De Gregorio et al propose a second variant referred to as "Modified DSP-Delayed NLMS", wherein $X_{n-1}$ is used instead of $X_n$ in the coefficient update, as shown in Figure 1(b), expressed as:

$$\text{M - DSP - DNLMS}: \begin{array}{l} (1) \ H_n = H_{n-1} + \mu e_{n-1} X_{n-1} \\ (2) \ e_n = d_n - H_{n-1} * X_n \end{array} \quad \text{(Equation 3)}.$$ It should be noted that the "N" in NLMS (Normalised LMS) represents the fact that the adaptation step $\mu$ is calculated with a normalisation factor corresponding to the energy of the reference signal history buffer as in NLMS. In fact, these algorithms may be referred to as DSP-LMS and M-DSP-LMS for a general step size as in LMS.

The "Modified DSP-Delayed LMS" version is characterized by better convergence properties as compared to "DSP-Delayed LMS" but nonetheless suffers from lower convergence speed compared to traditional LMS. This is due to the fact that the adaptation step $\mu$ has to be decreased as compared to a full-speed LMS, as explained below. The main difference between M-DSP-DLMS and traditional LMS, apart from a delay of one sample, is that the error used to update $H_{n-1}$ is actually calculated using $H_{n-2}$, whereas in LMS the error used to update $H_{n-1}$ is calculated using $H_{n-1}$.

A delayed version of the LMS (or NLMS) algorithm corresponding to the M-DSP-DLMS formulae above was known in the art prior to the article by De Gregorio et al and has been used in several applications such as adaptive equalisation, where decision-directed implementations result in some delay in the availability of the error signal (see "Combining echo cancellation and decision feedback equalisation," K.H. Mueller, Bell Syst. Tech. J., vol. 58, pp 491-500, Feb 1979), and adaptive reference echo cancellation in digital subscriber loops, where nonzero reference adaptation schemes also result in a delay in the availability of the error signal (see. "Adaptive reference echo cancellation," D. Falconer, IEEE Trans. Commun., vol. 30 (9), Sep 82).

In "The LMS algorithm with delayed coefficient adaptation," G. Long, F. Ling, J.G. Proakis, IEEE Trans. Ac., Speech and Sig. Proc., vol. 37 (9), pp 1397-1405, Sep 1989, the delayed LMS algorithm is defined as follows:

$$\text{DLMS}: \begin{array}{l} (1) \ e(T - D) = d(T - D) - X'(T - D).C(T - D - 1) \\ (2) \ C(T) = C(T - 1) + \beta e(T - D) X(T - D) \end{array} \quad \text{(Equation 4)},$$

where D is the amount of delay. It will be noted that for D=0, Equation 4 reduces to the traditional LMS algorithm, and for $D$=1, Equation 4 corresponds to the M-DSP-LMS algorithm of De Gregorio et al (modulo a one-sample delay in the error signal).

In "The stability of adaptive minimum mean square error equalisers using delayed adjustment," P. Kabal, IEEE Trans. Commun., vol. 31, pp 430-432, Mar. 1983, the following upper bound is established on the adaptation step for the convergence of the mean of the coefficient vector $C(T)$ to its optimum value (the Wiener solution):

$$0 < \beta < \frac{2}{\lambda_{max}} \sin\left(\frac{\pi}{2(2D+1)}\right) \quad \text{(Equation 5)},$$ where $\lambda_{max}$ is the maximum eigenvalue of the covariance matrix of the reference signal.

For NLMS and with D=1 to map onto the M-DSP-DNLMS algorithm of De Gregorio et al, this bound becomes:

$$0 < \mu < \sin\left(\frac{\pi}{5}\right) \cong 0.59 \quad \text{(Equation 6)}.$$ As discussed above, the maximum step size must be halved relative to NLMS (i.e. from $\mu = 1$ to $\mu \cong 0.5$) in order to keep the DNLMS algorithm stable. Because of the smaller adaptation step size, M-DSP-DNLMS exhibits slower convergence than traditional NLMS.

For some applications, this restriction on the maximum adaptation step size and its consequences on the adaptation speed may result in unacceptable performance. However, as discussed above, according to the present invention a further modification is provided to the DLMS algorithm to obtain an algorithm that is equivalent to LMS in terms of error signal and yet lends itself to a 2-cycles-per-tap implementation.

With reference to Figure 2, a realization diagram is provided for implementing a modified LMS (M-LMS) according to the preferred embodiment as follows:

$$\text{M - LMS} : \begin{array}{l} (1) \; H_n = H_{n-1} + \mu e_{n-1} X_{n-1} \\ (2) \; e_n = d_n - H_n * X_n \end{array} \quad \text{(Equation 7)}.$$

It will be appreciated that the coefficient adaptation does not require the result of the current error calculation, therefore in practice both steps can be executed in a single loop.

The differences between the M-LMS and traditional LMS algorithm are that the coefficient update is performed with the previous error $e_{n-1}$ instead of $e_n$, while the error is calculated using the updated coefficient vector $H_n$ instead of $H_{n-1}$. In terms of the error signal, these two differences actually compensate for each other, resulting in the exact same error signal as with LMS. The reason is that for a given sample n, the updated coefficient vector $H_n$ for M-LMS is exactly the same as the coefficient vector before update, $H_{n-1}$, for LMS. In other words, there is a one-sample delay in the update of the coefficient vector, but the fact that the error is calculated with the updated coefficient vector allows this delay to be completely transparent for the error signal.

Consequently, the performance of the M-LMS algorithm is exactly the same as that of LMS modulo a one-sample delay in the update of the coefficient vector (note that the reference history buffer has to be one sample longer than with LMS since the formulas make use of both $X_{n-1}$ and $X_n$.)

In order to achieve 2-cycles-per-tap implementation of the M-LMS algorithm according to the method of the present invention, a processor must be used that allows single-cycle multiply-and-accumulate (MAC) as well as dual-access memory. More particularly, the operations required for the common loop (that is, common to error calculation and coefficient vector update) are one multiply-and-accumulate for the error calculation, one multiplication and one addition for the coefficient update, two memory "reads" to fetch the reference history sample and the coefficient value needed for both the error calculation and the addition in the coefficient update, and one memory "write" to put the update coefficient back into memory. Provided the reference history buffer and the coefficient vector are stored in memory blocks allowing dual memory access (that is, which can be both accessed in the same processor cycle), these operations may be accomplished in two instructions (i.e. two cycles).

A 2-cycles-per-tap assembler-level implementation of the M-LMS algorithm has been implemented according to the preferred embodiment, with floating-point arithmetic on an Analog Devices SHARC processor, as shown in Figure 3.

Other assembly-level implementations on the same processor are possible using 2 cycles per tap. In particular, it is contemplated that it might be possible to use only one data memory register instead of two, and/or only one program memory register instead of two. Similarly, the code that prepares for the loop can also be optimised with multi-function instructions.

Also, when no adaptation is being performed, the LMS error calculation loop can be executed to calculate the error in one cycle per tap instead of using the common loop of Figure 2. This is useful for applications such as telephone conference units where talker localisation is typically performed during near-end speech in the absence of adaptation of the acoustic echo canceller (AEC), and for multi-channel implementations of a Line Echo Canceller (LEC) in order to free up cycles from non-adapting channels to channels needing adaptation.

In conclusion, the method of the present invention implements a modified LMS algorithm that can reduce the computational complexity of the LMS algorithm by 33% on most general-purpose Digital Signal Processors (DSPs) at virtually no cost in terms of performance or memory. The method is not application-specific and can be used in any of the traditional fields of control systems, adaptive channel equalisation, adaptive beamforming, and echo cancellation. It can also be combined with previously-known complexity-reduction schemes.

A specific embodiment of the present invention has been shown and described herein. However, modifications and variations may occur to those skilled in the art. For example, although the method of the present invention has been described for use in echo cancellation, it may be applied to any of the numerous fields of application to which the LMS algorithm has been traditional been applied, or may be applied in the future. All such modifications and variations are believed to be within the sphere and scope of the present invention.

**Claims**

1. A method for implementing a Least-Mean-Squares (LMS) adaptive digital filter for filtering a reference signal ($X_n$) using weighting coefficients ($H_n$) that are adapted by an error signal ($e_n$) equivalent to the difference between a desired signal ($d_n$) and the output $H_n$* $Xn$ of the adaptive filter, said method comprising:

updating said coefficient-vector *($H_n$)* using a previous sample of said error signal *($e_n$-1);* and
calculating said error signal *($e_n$)* using the updated coefficient-vector *($H_n$)*.

2. The method of claim 1, wherein said updated coefficient-vector *($H_n$)* and error signal *($e_n$)* are calculated as follows:

$$\text{M - LMS} : \begin{array}{l} (1) \ H_n = H_{n-1} + \mu e_{n-1} X_{n-1} \\ (2) \ e_n = d_n - H_n * X_n \end{array}$$

where $\mu$ is the adaptation step size of said digital filter.

2. For use in a general-purpose Digital Signal Processor (DSP), a method for implementing a Least-Mean-Squares (LMS) adaptive digital filter for filtering a reference signal ($X_n$) using weighting coefficients ($H_n$) that are adapted by an error signal ($e_n$) equivalent to the difference between a desired signal ($d_n$) and the output $H_n$* $Xn$ of the adaptive filter, said method comprising:

for each tap of said adaptive digital filter executing two cycles of said DSP for updating said coefficient-vector *($H_n$)* using a previous sample of said error signal *($e_{n-1}$)*, and calculating said error signal *($e_n$)* using the updated coefficient-vector *($H_n$)*.

3. The method of claim 2, wherein said updated coefficient-vector ($H_n$) and error signal ($e_n$) are calculated as follows:

$$\text{M - LMS} : \begin{array}{l} (1) \ H_n = H_{n-1} + \mu e_{n-1} X_{n-1} \\ (2) \ e_n = d_n - H_n * X_n \end{array}$$

where $\mu$ is the adaptation step size of said digital filter.

4. A Least-Mean-Squares (LMS) adaptive digital filter implemented within a general-purpose Digital Signal Processor (DSP) for filtering a reference signal ($X_n$) using weighting coefficients *($H_n$)* that are adapted by an error signal ($e_n$) equivalent to the difference between a desired signal ($d_n$) and the output $H_n$* $Xn$ of the adaptive filter, comprising:

a dual access memory for storing reference signal ($Xn$), and weighting coefficient vector ($H_n$); and
a multiply-and-accumulate block for executing a single-cycle generation of each tap of said weighting coefficients $H_n = H_{n-1} + \mu \, e_{n-1} X_{n-1}$ followed immediately by a single-cycle generation of each partial sum of said output $H_n$* $X_n$.

5. The Least-Mean-Squares (LMS) adaptive digital filter of claim 4, wherein said reference signal *($Xn$)* and weighting coefficient vector ($H_n$) are stored in memory blocks allowing them to be accessed in the same processor cycle.

Figure 1(a) PRIOR ART

Figure 1(b) PRIOR ART

Figure 2: modified LMS algorithm

## Figure 2

```
i5 = i4;  // address of reference signal history buffer
i12 = i13;     // address of adaptive filter coefficients


f2 = f4; // adaptation step times e(n-1)


// Preparation for weights update and error calculation loop


modify(i4,1);  // weights update uses X(n-1) instead of X(n)
f4 = dm(i4,m7);
f12 = f2 * f4; // first tap of weights update vector
f8 = pm(i12,m15);
f0 = f8 + f12; // first tap of updated weights vector. Will be put back
               // to memory in the main loop
f8 = pm(i12,m15);
f4 = dm(i4,m7);
f12 = f2 * f4; // second tap of weights update vector
f4 = dm(i4,m7);


f13 = 0;  // filter output accumulation
f5 = dm(i5,m7);
f9 = f0 * f5;  // first component of filter output accumulation (using
               // updated first tap of weights vector)


// 2 cycles per tap in the loop


lcntr = r3, do (pc,0x2) until lce;
f12 = f2 * f4, f0 = f8 + f12, f5 = dm(i5,m7), pm(i13,m15) = f0;
f9 = f0 * f5, f13 = f9 + f13, f4 = dm(i4,m7), f8 = pm(i12,m15).
```

## Figure 3

**EP 1 841 065 A1**

European Patent Office

**EUROPEAN SEARCH REPORT**

Application Number

EP 06 11 1900

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 0 373 468 A (MOTOROLA INC; MOTOROLA, INC) 20 June 1990 (1990-06-20) <br> * abstract * <br> * page 2, line 19 - line 25 * <br> * page 4, line 9 - line 12 * <br> * page 4, line 31 - page 5, line 54; figures 3,4 * <br> * page 5, line 55 - page 7, line 52; figures 5,6 * <br> ----- | 1-6 | INV. <br> H03H21/00 |
| A | EP 1 176 718 A (VIA TECHNOLOGIES, INC) 30 January 2002 (2002-01-30) <br> * abstract * <br> * page 2, paragraph 9 - page 3, paragraph 17; figure 3 * <br> * page 4, paragraph 26 - page 5, paragraph 34; figure 4 * <br> ----- | 1-6 | |
| A | US 2003/028569 A1 (BROKISH CHARLES W) 6 February 2003 (2003-02-06) <br> * abstract * <br> * page 1, paragraph 4 - paragraph 7 * <br> * page 2, paragraph 21 - page 4, paragraph 40; figures 1A,1B * <br> * page 4, paragraph 41 - page 5, paragraph 51 * <br> ----- | 1-6 | TECHNICAL FIELDS SEARCHED (IPC) <br><br> H03H |
| D,A | GUOZHU LONG ET AL: "THE LMS ALGORITHM WITH DELAYED COEFFICIENT ADAPTATION" IEEE TRANSACTIONS ON ACOUSTICS, SPEECH AND SIGNAL PROCESSING, IEEE INC. NEW YORK, US, vol. 37, no. 9, 1 September 1989 (1989-09-01), pages 1397-1405, XP000054415 ISSN: 0096-3518 <br> * page 1397 * <br> ----- | 1-6 | |

The present search report has been drawn up for all claims

| Place of search | Date of completion of the search | Examiner |
|---|---|---|
| Munich | 31 August 2006 | Trafidlo, R |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

9

**EP 1 841 065 A1**

## ANNEX TO THE EUROPEAN SEARCH REPORT
## ON EUROPEAN PATENT APPLICATION NO.

EP 06 11 1900

This annex lists the patent family members relating to the patent documents cited in the above-mentioned European search report.
The members are as contained in the European Patent Office EDP file on
The European Patent Office is in no way liable for these particulars which are merely given for the purpose of information.

31-08-2006

| Patent document cited in search report | | Publication date | Patent family member(s) | | Publication date |
|---|---|---|---|---|---|
| EP 0373468 | A | 20-06-1990 | DE | 68926154 D1 | 09-05-1996 |
| | | | DE | 68926154 T2 | 24-10-1996 |
| | | | JP | 2214322 A | 27-08-1990 |
| | | | JP | 2960086 B2 | 06-10-1999 |
| | | | US | 4947363 A | 07-08-1990 |
| EP 1176718 | A | 30-01-2002 | JP | 2002152014 A | 24-05-2002 |
| | | | US | 6714956 B1 | 30-03-2004 |
| US 2003028569 | A1 | 06-02-2003 | US | 6665695 B1 | 16-12-2003 |

EPO FORM P0459

For more details about this annex : see Official Journal of the European Patent Office, No. 12/82

10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4947363 A
- US 10374738 B
- US 20040015529 A
- US 19990431847 A
- US 20030223575 A
- US 11027515 B
- US 20050117739 A1
- US 1992000894377 A

**Non-patent literature cited in the description**

- **B. WIDROW ; M.E. HOFF.** Adaptive switch circuits. *IRE WESCON Convention Record,* 1960, 96-104
- Least-Mean-Square adaptive filters. Wiley, 2003
- **J. BENESTY ; T.F. GAENSLER ; D.R. MORGAN ; M.M. SONDHI ; S.L. GAY.** Advances in network and acoustic echo cancellation. Springer, 2001
- **E. HANSLER ; G. SCHMIDT.** Acoustic echo and noise control, a practical approach. Wiley, 2004
- **S. DE GREGORIO ; J. CHAOUI ; Y. MASSE.** Trade-offs in DSP implementations of NLMS-based echo cancellers. *Proc. ICSPAT '98,* September 1998, vol. 1, 72-76
- **K.H. MUELLER.** Combining echo cancellation and decision feedback equalisation. *Bell Syst. Tech. J.,* February 1979, vol. 58, 491-500
- **D. FALCONER.** Adaptive reference echo cancellation. *IEEE Trans. Commun.,* September 1982, vol. 30 (9
- **G. LONG ; F. LING ; J.G. PROAKIS.** The LMS algorithm with delayed coefficient adaptation. *IEEE Trans. Ac., Speech and Sig. Proc,* September 1989, vol. 37 (9), 1397-1405
- **P. KABAL.** The stability of adaptive minimum mean square error equalisers using delayed adjustment. *IEEE Trans. Commun.,* March 1983, vol. 31, 430-432